# EUROPEAN PATENT APPLICATION

(11) **EP 4 561 276 A1**
(43) Date of publication of application: **28.05.2025**
(21) Application number: 23844930.0
(22) Date of filing: 25.04.2023
(51) Int. Cl.: H05K 5/02, G02B 5/18

(54) **DECORATIVE MEMBER, HOUSING OF ELECTRONIC DEVICE, AND ELECTRONIC DEVICE**

(30) Priority: 26.07.2022 CN 202221961700 U
(71) Applicant: BYD Company Limited, Shenzhen, Guangdong 518118 (CN)
(72) Inventor: YUAN, Sun, Shenzhen, Guangdong 518118 (CN); DUAN, Feifei, Shenzhen, Guangdong 518118 (CN); ZHAO, Lihong, Shenzhen, Guangdong 518118 (CN); ZHU, Qiyu, Shenzhen, Guangdong 518118 (CN); LUO, Wenhai, Shenzhen, Guangdong 518118 (CN)
(74) Representative: Taor, Simon Edward William
(86) International application number: PCT/CN2023/090697
(87) International publication number: WO 2024/021715

(57) **Abstract**

Provided are a decorative member, a housing of an electronic device, and an electronic device. The decorative member comprises a substrate (1) and a first texture layer (2) provided on the substrate (1). The first texture layer (2) has a plurality of preset paths. A plurality of grating elements (3) arranged in sequence are provided on each preset path to jointly present the shape of hair strands. Grating elements (3) on two adjacent preset paths have different angles.

## Description

### CROSS-REFERENCE TO RELATED APPLICATIONS

The present disclosure claims priority to Chinese Patent Application No. 202221961700.3 filed on July 26, 2022, titled "DECORATIVE MEMBER, HOUSING OF ELECTRONIC DEVICE, AND ELECTRONIC DEVICE", which is incorporated herein by reference in its entirety.

### FIELD

The present disclosure relates to the field of optical technologies, specifically to a decorative member, a housing of an electronic device, and an electronic device.

### BACKGROUND

In the related art, the hairline effect presented by the decorative member is mostly achieved by surface treatment on the corresponding substrate by the printing or hot pressing process, and forming a surface texture pattern with hairline-like characteristics on the surface of the substrate. However, the hairline effect formed by this method is too rigid, has poor fluidity, and has insufficient aesthetics, and the hairline flowing effect cannot be presented under various viewing angles.

### SUMMARY

In view of this, the present disclosure provides a decorative member, a housing of an electronic device, and an electronic device to at least partially solve problems existing in the related art.

According to a first aspect of the present disclosure, a decorative member is provided. The decorative member includes: a substrate; and
a first texture layer, arranged on the substrate. The first texture layer has a plurality of preset paths, and each of the preset paths has a plurality of grating portions arranged in sequence, in order to jointly present a hairline shape. The grating portions on the two adjacent preset paths are arranged at different angles.

According to an example of the present application, a surface of the substrate is divided into a plurality of unit cell areas of the same size, and each of the unit cell areas is filled with one of the grating portions.

According to an example of the present application, the unit cell area is a square, and each of the grating portions is centered at the center of the square, each of the grating portions extends to an inscribed circle of the square and connects to the inscribed circle of the square, or each of the grating portions extends to an edge of the square and connects to the edge of the square.

According to an example of the present application, the unit cell area is a square, and a side length of the square is 40 microns to 100 microns.

According to an example of the present application, a width of a cross section of each of the grating portions is 20% to 60% of the side length of the square, and the cross section is perpendicular to the corresponding preset path.

According to an example of the present application, the tangent value of the included angle is between 1:30 and 4: 1, and the included angle is between the reflecting surface of each of the grating portions and the surface of the substrate.

According to an example of the present application, a height of each of the grating portions is 0.5 microns to 20 microns, a width of a cross section of each of the grating portions is 10 microns to 50 microns, and the cross section is perpendicular to the corresponding preset path.

According to an example of the present application, at least part of grating portions on each of the preset paths are arranged at different angles.

According to an example of the present application, the grating portion includes at least one of a grating portion extending in a straight line and a grating portion extending in a curve.

According to an example of the present application, the grating portion includes at least one of a curved grating portion having a reflecting surface configured as a curved surface and a planar grating portion having a reflecting surface configured as a planar surface.

According to an example of the present application, a surface of the substrate is further arranged with a second texture layer having an effect different from that of the first texture layer,

the first texture layer and the second texture layer are respectively arranged in different areas of the substrate, or the first texture layer and the second texture layer are both arranged on the entire surface of the substrate and arranged in an intersecting manner.

According to a second aspect of the present disclosure, a housing of an electronic device is provided, and the housing of the electronic device includes the decorative member provided in the present disclosure.

According to a third aspect of the present disclosure, an electronic device is provided, and the electronic device includes the housing of the electronic device provided in the present disclosure.

According to the above technical solution, a plurality of grating portions are arranged on a preset path to form a hairline effect, and the displayed effect of hairline light and shadow is realized to be more natural and not rigid. Moreover, the grating portions of adjacent hairlines are arranged at different angles, resulting in different light and shadow effects on two adjacent hairlines. While the boundary of the hairline is clear, it can also make the hairline flash alternately at different viewing angles, thus enhancing the flexibility and aesthetics of the decorative member.

Other features and advantages of the present disclosure will be described in detail in the following examples.

### BRIEF DESCRIPTION OF THE DRAWINGS

The accompanying drawings are intended to provide a further understanding of the present disclosure and constitute a part of the specification and, together with the following examples, serve to explain the present disclosure, but are not intended to limit the present disclosure. In the drawings:
FIG. 1 is a light and shadow effect diagram of a decorative member according to an exemplary example of the present disclosure;
FIG. 2 is a partial enlarged view of a texture layer of a decorative member according to an exemplary example of the present disclosure;
FIG. 3 is an arrangement diagram of partial grating portions of a decorative member according to an exemplary example of the present disclosure;
FIG. 4 is an arrangement diagram of a grating portion according to an exemplary example of the present disclosure;
FIG. 5 is a top view of partial grating portions of a decorative member according to an exemplary example of the present disclosure;
FIG. 6 is a display effect diagram corresponding to arrangement angles of grating portions according to an exemplary example of the present disclosure;
FIG. 7 is a cross-sectional view of grating portions according to an exemplary example of the present disclosure;
FIG. 8 is a cross-sectional view of grating portions according to another exemplary example of the present disclosure;
FIG. 9 is a cross-sectional view of grating portions according to another exemplary example of the present disclosure;
FIG. 10 is an arrangement diagram of partial grating portions of a decorative member according to an exemplary example of the present disclosure.

### DETAILED DESCRIPTION

Hereinafter, specific examples of the present disclosure will be described in detail with reference to the accompanying drawings. It should be understood that the specific example described herein is for illustration and explanation of the present disclosure only, and is not intended to limit the present disclosure.

In the present disclosure, unless stated to the contrary, location words such as "inner and outer" are used with respect to the contour of the corresponding component itself. In addition, when the following description refers to the drawings, the same numbers in different drawings denote the same or similar elements unless otherwise indicated. The examples described in the following exemplary examples do not represent all examples consistent with the present disclosure. Rather, they are merely examples of devices and methods consistent with some aspects of the present disclosure as detailed in the appended claims.

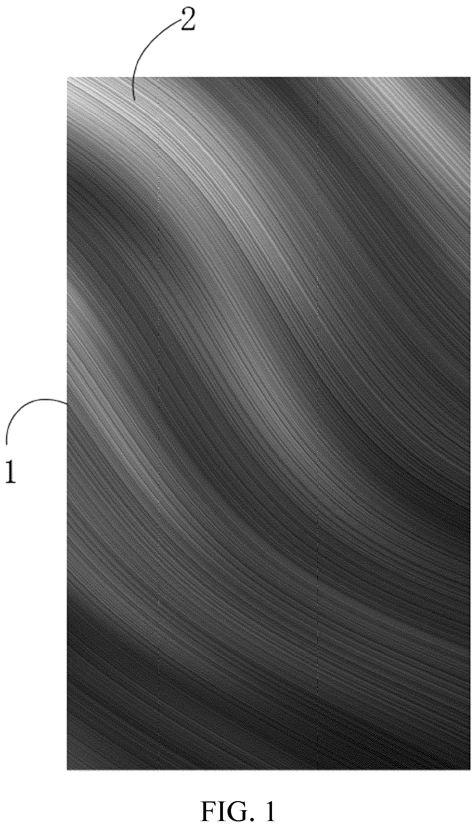

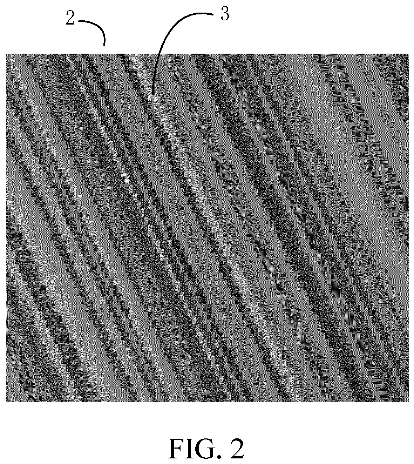

According to a first aspect of the present disclosure, a decorative member is provided, and the decorative member can be arranged on various products to improve aesthetics. For example, the decorative member can serve as a housing of an electronic device to present a desired light and shadow effect. Specifically, referring to FIGS. 1 and 2, the decorative member includes a substrate 1 and a first texture layer 2 arranged on the substrate 1. Here, the substrate 1 can be made of the transparent material having a certain refractive index, for example, PC (Polycarbonate) sheet, PET (polyethylene terephthalate) sheet, or PC/PMMA (polymethyl methacrylate) composite sheet, and the substrate 1 can be a glass plate. Of course, the substrate 1 made of the non-transparent material can also be applied to the decorative member of the present disclosure without affecting the presentation of the effect of the first texture layer 2.

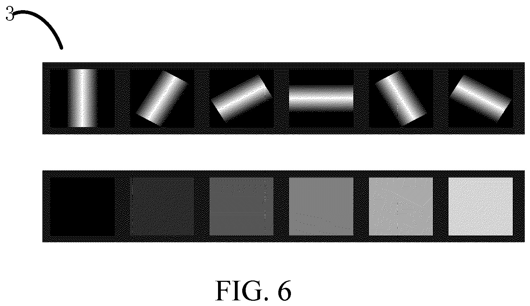

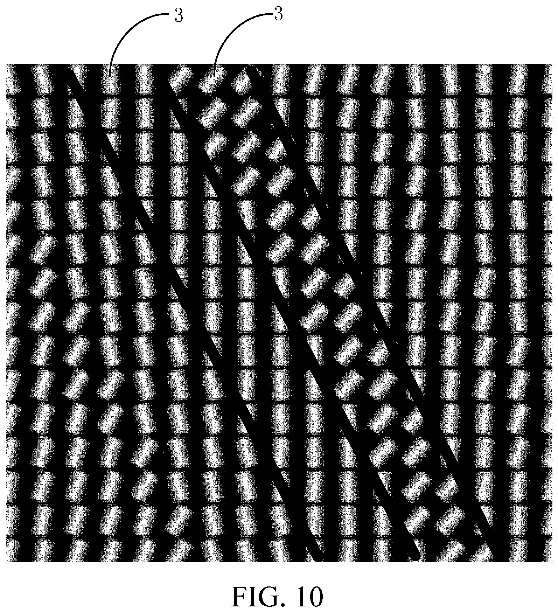

As shown in FIGS. 1 and 2, the first texture layer 2 has a plurality of preset paths, and each of the preset paths has a plurality of grating portions 3 arranged in sequence, in order to jointly present a hairline shape. A width of the hairline can be determined by the size and number of the grating portion 3. For example, referring to FIG. 10, the arrangement of the partial grating portions 3 of a single hairline is roughly outlined by a thick black line in FIG. 10, and the extension direction outlined by the thick black line can be understood as a preset path. In FIG. 10, the area between two adjacent thick black lines represents the arrangement of partial grating portions 3 of the single hairline. As shown in FIG. 10, a single hairline can be composed of a plurality of columns of a plurality of grating portions 3 arranged on the preset path to form a thicker hairline effect. In other examples, only one column of grating portions 3 can be arranged on the preset path to form a thinner hairline effect. FIG. 2 is a reduced view effect relative to FIG. 10, but only partial texture layer is shown, without showing the entire hairline. In FIG. 2, a plurality of successive pixel grids form a single hairline on the preset path. The grating portions 3 in FIG. 2 form a plurality of hairlines on a plurality of preset paths, thus having an effect of hairline light and shadow. In FIG. 2, the hairline with a wider pixel grid is formed by a plurality of columns of grating portions, and the hairline with a thinner pixel grid is formed by one column of grating portions. In conjunction with FIG. 6, FIG. 6 shows the light and shadow effects when the grating portions 3 are observed at the same viewing angle, from left to right, the light and shadow reflected by the grating portions 3 at the same viewing angle changes from dark to bright as the arrangement angles of the grating portions 3 change. However, it should be noted here that when these grating portions 3 are viewed from other viewing angles, the corresponding light and shadow effects also change, rather than being limited to the effects shown in FIG. 6, which illustrates only one viewing angle as an example. Among them, in the example of the present disclosure, referring to FIG. 10, the grating portions 3 on the two adjacent preset paths (that is, the two paths drawn by three thick black lines in FIG. 10) are arranged at different angles, and the grating portions 3 on the path close to the right of the two paths drawn in FIG. 10 are rotated approximately by 45 ° with respect to the grating portions 3 of the path on the left, which is merely illustrative and is not intended to limit the present disclosure. In other words, the adjacent grating portions 3 constituting the two adjacent hairlines are arranged at different angles, so that the two adjacent hairlines can present different light and shadow effects when viewed at the same viewing angle.

According to the above technical solution, a plurality of grating portions 3 are arranged on a preset path to form a hairline effect, and the displayed effect of hairline light and shadow is realized to be more natural and not rigid. Moreover, the grating portions 3 of adjacent hairlines are arranged at different angles, resulting in different light and shadow effects on two adjacent hairlines. While the boundary of the hairline is clear, it can also make the hairline flash alternately at different viewing angles, thus enhancing the flexibility and aesthetics of the decorative member.

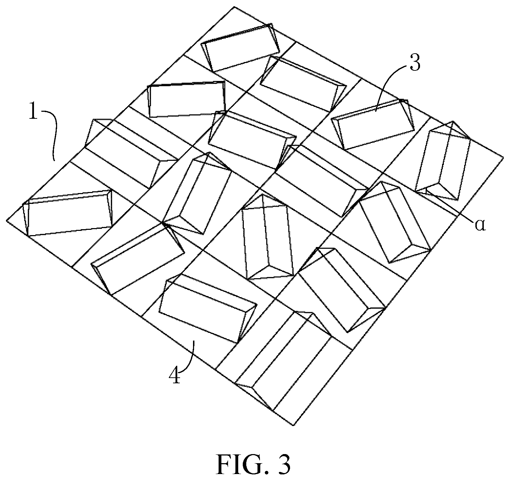

In the example of the present disclosure, referring to FIG. 3, a surface of the substrate 1 is divided into a plurality of unit cell areas 4 of the same size, and each of the unit cell areas 4 is filled with one of the grating portions 3.Here, the unit cell area 4 is constructed to facilitate the arrangement of the grating portion 3 at the time of design, and the borders of the unit cell area 4 are not displayed in the product of the decorative member. Each of the unit cell areas 4 is arranged with a grating portion 3 through this arrangement, thus making the transition of light and shadow effects finally presented consistent and natural.

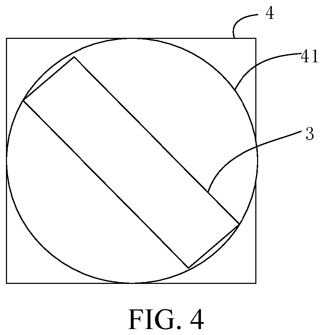

Further, referring to FIG. 4, the unit cell area 4 can be a square, and each of the grating portions 3 can be centered at the center of the square, that is, the center of the grating portion 3 can coincide with the center of the square. The grating portion 3 can extend to an inscribed circle 41 of the square and connect to the inscribed circle 41 of the square. In this way, it can ensure that the size of each of the grating portions 3 is the same, thus making the displayed light and shadow effects more uniform. Among them, the inscribed circle 41 here and the above-mentioned square are both constructed to facilitate the arrangement of the grating portion 3 at the time of design, and the borders of both are not displayed in the product of the decorative member.

In other examples, each of the grating portions 3 can also be arranged to be connected to an edge of the unit cell area 4 as shown in FIG. 3, making the light and shadow effects coherent and smooth, thus having a naturally flowing effect.

According to one example of the present disclosure, a side length of the square can be set to 40-100 microns, for example, 50 microns. By defining the unit cell area 4 to this size, the size of the grating portion 3 in the unit cell area 4 can also ensure the naturally flowing effect of light and shadow on the premise of ensuring that it is technically easy to realize.

According to one example of the present disclosure, the tangent value of the included angle α (referring to FIG. 3) can be between 1:30 and 4:1, and the included angle is between the reflecting surface of each of the grating portions 3 and the surface of the substrate 1. For example, when the grating portion 3 is a regular triangular prism shown in FIG. 3, for example, when a height of the grating portion 3 (that is, the size of the grating portion 3 in the direction perpendicular to the surface of the substrate 1) is 0.5 microns, the corresponding width of the grating portion 3 (that is, a width of the surface on which the triangular prism is bonded to the substrate 1) can be 30 microns. The range of tangent values can avoid presenting only flat effects due to excessive width, as well as avoiding non tilted reflecting surface effects due to insufficient width.

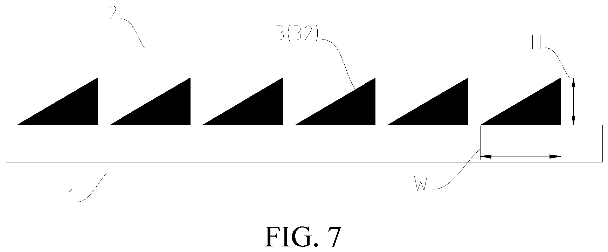

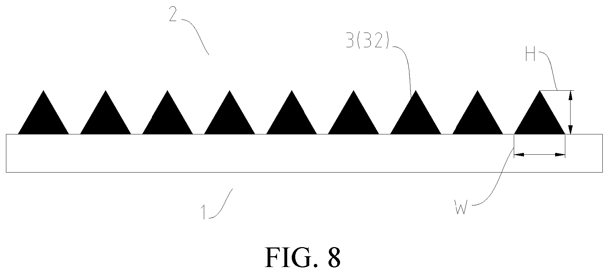

In one example, in conjunction with FIGS. 7 and 8, a height H of each of the grating portions 3 can be 0.5 microns to 20 microns, a width W of a cross section of each of the grating portions 3 can be 10 microns to 50 microns, and the cross section is perpendicular to the corresponding preset path. A flowing hairline light and shadow effect with continuity can be achieved by the grating portion 3 within the size range. Further, placing the grating portion 3 of the size in the unit cell area which is a square having a side length of 50 microns is more conducive to obtaining better light and shadow effects.

In one example, the size of the grating portion 3 can be determined according to the side length of the square, for example, a width of a cross section of the grating portion 3 can be 20% to 60% of the side length of the square, for example 50% of the side length of the square, and the cross section is perpendicular to the corresponding preset path. For example, when the side length of the square is 50 microns, the width of the grating portion 3 can be 10 to 30 microns, such as 20 microns. With this arrangement, clear and visible light and shadow effects can be obtained without being blurred due to too large size or being invisible due to too small size

In the example of the present disclosure, at least part of grating portions 3 on each of the preset paths are arranged at different angles. By arranging the grating portions 3 at different angles, the grating portions 3 are changed with the effect of hairline flowing, so as to realize the effect of hairline flowing. In some examples, in order to realize the flowing light and shadow effect, part of adjacent grating portions along the preset path can be divided into a group, thus the preset path can be divided into a plurality of groups of gratings. The angles of grating portions 3 in each group of gratings can be the same, and the angles of gratings of adjacent groups can be set to be different. In this way, the grating portions 3 of the same angle within the same group are used to form hairline light and shadow, while the angle changes of the gratings between different groups can present light and shadows of different brightness to form a flowing hairline effect. For example, in some examples, the arrangement angle of the grating portion along a preset path of a hairline can be as follow: the arrangement angle of a group of grating portions 3 at the starting end (here all angles are relative to the grating in the vertical direction) is 10°, and the arrangement angle of a group of grating portions 3 at the end is 80°. The grating groups between the starting end and the end can be changed sequentially within the angle range, and in this arrangement, the effect of flowing hairline can be presented, that is, when viewed from a perspective, different light and dark effects are presented sequentially on a single hairline in a preset path (as shown in FIG. 1), thus obtaining a flowing hairline texture. When the arrangement angle of a hairline is between 10° and 80°, the arrangement angles of two hairlines can be 20° to 90° and 0° to 70°, respectively, and the two hairlines are adjacent to the hairline and on both sides of the hairline. Here, the arrangement angles of adjacent hairlines, and the arrangement angles of a single hairline are only described as examples, and in practical application, it can be adjusted according to the light and shadow effects to be displayed.

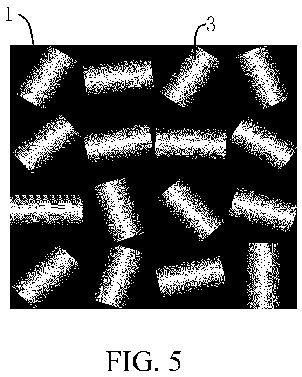

In an example of the present disclosure, the grating portion 3 can include at least one of a grating portion 3 extending in a straight line and a grating portion 3 extending in a curve. The grating portion 3 extending in a straight line is, for example, the grating portion 3 shown in FIGS. 3 to 5, and the grating portion 3 extending in a curve can be, for example, S-shaped extending, arc-shaped extending, or the like. In the example of the present disclosure, referring to FIGS. 7 to 9, the grating portion 3 can include at least one of a curved grating portion 31 having a reflecting surface configured as a curved surface and a planar grating portion 32 having a reflecting surface configured as a planar surface. For example, in a decorative member, the first texture layer 2 can include one of the aforementioned grating portions or a combination of various grating portions, and the types of grating portions 3 on the same preset path can be the same or different. The curved reflecting surface can reflect from different angles, and the reflection intensity is slightly weaker than that of the planar reflecting surface. In practical application, the configuration of the grating portion 3 of the first texture layer 2 can be set according to the desired light and shadow effects.

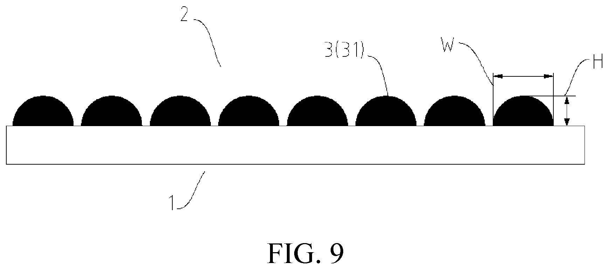

In some examples, as shown in FIG. 9, the curved grating portion 31 can include a grating portion having the cross section configured as an arc shape, and the cross section is perpendicular to the corresponding preset path. The arc surface has several tangent lines, which can reflect light from different angles, thus making the light and shadow effect softer. As shown in FIGS. 7 and 8, the planar grating portion 32 can include a grating portion having the cross section configured as a triangular shape, and the cross section is perpendicular to the corresponding preset path. Because the reflecting surface of this grating portion is planar, the reflective intensity is greater, and the effect is brighter than that of the arc-shaped one. In the example of the present disclosure, the cross-sectional shape of the grating portion 3 is not limited thereto, and will not be described in detail here.

In some examples, referring to FIG. 7, the planar grating portion 32 can include a right angle grating portion having the cross section configured as a right angle triangle shape, and the cross section is perpendicular to the corresponding preset path. In one example of the present disclosure, the first texture layer 2 of the decorative member can be adjacently arranged with right angle grating portions on a plurality of adjacent preset paths, and the arrangement direction of the hypotenuse of the adjacent right angle grating portions is the same. A right angle side of the adjacent right angle grating portion is attached to the substrate 1, and the other right-angle side is adjacent to the hypotenuse of the adjacent right-angle grating portion. In this way, a plurality of right-angle grating portions are arranged adjacently to form an effect similar to that of a Fresnel lens, making the light and shadow effects presented transparent. In the example of the present disclosure, a combination of a plurality of grating portions 3 can be arranged according to the light and dark requirements of light and shadow, so that the light and shadow effect presented by the decorative member is natural and not rigid.

In one example, a surface of the substrate 1 can be further arranged with a second texture layer having an effect different from that of the first texture layer 2. In some examples, the first texture layer 2 and the second texture layer can be respectively arranged in different areas of the substrate 1, for example, the substrate 1 is divided into two areas, the first texture layer 2 is arranged in one area, and the second texture layer is arranged in the other area, so that two kinds of light and shadow effects can be presented on the decorative member, which has peculiarity. Similarly, three or more areas can also be divided on the substrate 1, and each area is arranged with a different texture layer. In some examples, the first texture layer 2 and the second texture layer can be arranged on the entire surface of the substrate 1 and arranged in an intersecting manner, that is, a new light and shadow effect can be presented after the first texture layer 2 and the second texture layer arranged in an intersecting manner. In addition, it should be noted that in the example of the present disclosure, a combination of the above two methods can be adopted, that is, a part of the first texture layer 2 and the other texture layer can be arranged in the same area and arranged in an intersecting manner, and the other part of the first texture layer 2can be arranged independently of the texture layer of the other area, to make the decorative member present various light and shadow effects.

According to a second aspect of the example of the present disclosure, a housing of an electronic device is further provided. The housing of the electronic device includes the above-described decorative member and has all the beneficial effects of the above-described decorative member, which will not be described herein. In some examples, the housing of the electronic device can include a coating layer located on the surface of the decorative member in addition to the above-described decorative member, and the light and shadow effects of different colors can be presented in conjunction with the above-described decorative member having a hairline flowing effect. Of course, other functional layers can be added according to actual needs, or more decorative members can be superimposed.

According to a third aspect of the present disclosure, an electronic device is further provided. The electronic device includes the housing of the electronic device described above to improve a visual effect. Among them, electronic devices include but are not limited to mobile phones, tablets, laptops, etc.

Hereinafter, a method for preparing a product of the decorative member will be described in conjunction with the decorative member in the example of the present disclosure. The method for preparing the product of the decorative member includes the following steps: texture parameters are set by software, the preset texture is carved onto the mould by laser, and exposing, developing, drying, plasma cleaning and other operations are operated on the mould to obtain a texture mould; transferring and curing operations are operated on the texture mould to obtain the transfer mould; the texture is transferred to the substrate 1 to transfer an optical texture layer on the substrate 1; a coating layer is deposited on the optical texture layer, and an ink layer is printed on one side of the coating layer; then, the film of the decorative member is attached to the glass by a process such as bonding to make a glass product having the decorative member. In other methods, it is possible to apply a preset texture to the glass product with homogeneous photoresist, and the preset texture structure can be obtained by photolithography, exposure and development; the glass with a texture layer is placed in an etching tank, and the texture is completely copied onto the glass through a reasonable etching time to form a decorative member in the present disclosure, wherein a glass plate is used as the substrate 1 here; then, optical coating can be performed on the side opposite the texture layer of the glass; and an ink layer is sprayed on one side of the coating layer, thereby obtaining a product having a decorative member.

Preferred examples of the present disclosure are described in detail above with reference to the accompanying drawings, but the present disclosure is not limited to the specific details in the above-described examples, and various simple modifications can be made to the technical solutions of the present disclosure within the scope of the technical concept of the present disclosure, and these simple modifications all fall within the scope of protection of the present disclosure.

In addition, it should be noted that the specific technical features described in the above-described detailed examples can be combined in any suitable manner without contradiction, and in order to avoid unnecessary repetition, various possible combinations will not be described separately in the present disclosure.

In addition, various different examples of the present disclosure can be arbitrarily combined, and the same should be regarded as the contents disclosed in the present disclosure as long as they do not violate the concept of the present disclosure.

## Claims

1. A decorative member, comprising:
a substrate (1); and
a first texture layer (2), arranged on the substrate (1), the first texture layer (2) having a plurality of preset paths, each of the preset paths having a plurality of grating portions (3) arranged in sequence to jointly present a hairline shape, and the grating portions (3) on the two adjacent preset paths being arranged at different angles.

2. The decorative member according to claim 1, wherein a surface of the substrate (1) is divided into a plurality of unit cell areas (4) of the same size, and each of the unit cell areas (4) is filled with one of the grating portions (3).

3. The decorative member according to claim 2, wherein the unit cell area (4) is a square, each of the grating portions (3) is centered at the center of the square, and each of the grating portions (3) extends to an inscribed circle (41) of the square and connects to the inscribed circle (41) of the square, or each of the grating portions (3) extends to an edge of the square and connects to the edge of the square.

4. The decorative member according to claim 2 or 3, wherein the unit cell area (4) is a square, and a side length of the square is 40 microns to 100 microns.

5. The decorative member according to claim 3 or 4, wherein a width of a cross section of each of the grating portions (3) is 20% to 60% of the side length of the square, and the cross section is perpendicular to the corresponding preset path.

6. The decorative member according to any one of claims 1 to 5, wherein the tangent value of the included angle is between 1:30 and 4: 1, and the included angle is between the reflecting surface of each of the grating portions (3) and the surface of the substrate (1).

7. The decorative member according to any one of claims 1 to 6, wherein a height of each of the grating portion (3) is 0.5 microns to 20 microns, a width of a cross section of each of the grating portions (3) is 10 microns to 50 microns, and the cross section is perpendicular to the corresponding preset path.

8. The decorative member according to any one of claims 1 to 7, wherein at least part of grating portions (3) on each of the preset paths are arranged at different angles.

9. The decorative member according to any one of claims 1 to 8, wherein the grating portions (3) comprise at least one of a grating portion extending in a straight line and a grating portion extending in a curve.

10. The decorative member according to any one of claims 1 to 9, wherein the grating portions (3) comprise at least one of a curved grating portion (31) having a reflecting surface configured as a curved surface and a planar grating portion (32) having a reflecting surface configured as a planar surface.

11. The decorative member according to any one of claims 1 to 10, wherein a surface of the substrate (1) is further arranged with a second texture layer having an effect different from the first texture layer (2),
the first texture layer (2) and the second texture layer are respectively arranged at different areas of the substrate (1), or the first texture layer (2) and the second texture layer are both arranged on the entire surface of the substrate (1) and arranged in an intersecting manner.

12. A housing of an electronic device, comprising a decorative member according to any one of claims 1 to 11.

13. An electronic device, comprising a housing of the electronic device according to claim 12.
